# EUROPEAN PATENT SPECIFICATION

(11) **EP 0 431 595 B1**
(45) Date of publication and mention of the grant of the patent: **08.06.1994**
(21) Application number: 90123319.7
(22) Date of filing: 05.12.1990
(51) Int. Cl.: H01B 12/06, H01L 39/12

(54) **Oxide superconducting thin film**
Dünnfilm aus supraleitendem Oxid
Couche mince en oxyde supraconducteur

(30) Priority: 07.12.1989 JP 318252/89; 15.12.1989 JP 326727/89; 16.11.1990 JP 311976/90
(43) Date of publication of application: 12.06.1991
(73) Proprietor: SUMITOMO ELECTRIC INDUSTRIES, LTD., Osaka-shi, Osaka 541 (JP); The Tokyo Electric Power Co., Inc., Chiyoda-ku Tokyo (JP)
(72) Inventor: Takano, Satoshi, c/o Osaka Works, Konohana-ku, Osaka (JP); Okuda, Shigeru, c/o Osaka Works, Konohana-ku, Osaka (JP); Yoshida, Noriyuki, c/o Osaka Works, Konohana-ku, Osaka (JP); Hara, Tsukushi, c/o The Tokyo Electric, Chiyoda-ku, Tokyo (JP); Okaniwa, Kiyoshi, c/o The Tokyo Electric, Chiyoda-ku, Tokyo (JP); Yamamoto, Takahiko, c/o The Tokyo Electric, Chiyoda-ku, Tokyo (JP)
(74) Representative: KUHNEN, WACKER & PARTNER

(56) References cited:
- EP-A- 0 294 285
- SPIE, vol. 948, 1988, Washington, USA "High-Tc Superconductivity: Thin Films and Devices" X.D. WU et al. "Versatility of pulsed laser deposition technique for preparation of high Tc superconducting thin films" pages 50-65

## Description

### Field of the Invention

The present invention relates to an oxide superconducting thin film, and more particularly, it relates to an oxide superconducting thin film which can attain high critical current density.

### Description of the Background Art

In order to put an oxide superconductive material into practice, an appropriate substrate is prepared to form an oxide superconducting thin film on this substrate. A superconducting wire can be obtained by using a long substrate.

In general, a thin film is formed by a vapor phase method, for example, such as sputtering, vapor deposition, CVD, MBE or the like.

The practical use of an oxide superconductive material is hindered, however, on the ground that it is not so easy to attain high critical current density.

A prior art approach to provide a superconducting thin film having a higher critical current density is disclosed in the EP-A-0 294 285. According to this document a superconducting thin film is composed of compound oxide containing at least one element of the group comprising Y, La, Gd, Ho, Er, Tm, Yb, Dy, Nd, Sm, Eu and Lu, Ba and Cu. To increase the critical current density and the critical temperature, it is suggested in this document to provide a crystal structure whose c-axis is orientated to a predetermined direction. According to a preferred embodiment, the direction of the c-axis is orientated to a direction which is perpendicular to the plane defined by a the a-axis and the b-axis of the crystal. In accordance with this document, the direction of the orientation of the c-axis is determined by the nature of the surface of the substrate or the nature of the crystal face on which the thin film has to be deposited.

From SPIE, Vol. 948, 1988, Washington, USA, "High-Tc Superconductivity: Thin Films and Devices" X. D. Wu et al. "Versatility of pulsed laser deposition technique for preparation of high Tc superconducting thin films" pages 50 - 65, a pulsed laser deposition (PLD) technique is known for preparing high T_{c} superconducting thin films. By using this technique, superconducting thin films of Y-Ba-Cu Oxide with zero resistance temperature over 80 K and below 650 °C (processing temperature) have been obtained. The critical current densities in the films prepared at low temperature on SrTiO₃ where in the order of 5 x 10⁵ A/cm² at 77 K. One of the films prepared has had an orthorhombic structure with the c-axis normal to the substrate surface.

In view of these prior art approaches, it is the object of the present invention to provide oxide superconducting thin films formed by laser ablation techniques having an improved critical current density.

This object is solved by an oxide superconducting thin film according to claim 1.

In more detail, the present invention is directed to an oxide superconducting thin film, which is formed by laser ablation. In order to solve the aforementioned technical problem, the inventive oxide superconducting thin film comprises a matrix formed of c-axis oriented superconducting phases and foreign phases which are different in crystal orientation from the matrix.

The inventors have made deep study as to improvement in critical current density of oxide superconducting thin films obtained by various vapor phase methods, to find that an oxide superconducting thin film having the aforementioned structure provides the most excellent critical current density. For example, it has been recognized that an oxide superconducting thin film substantially comprising only a matrix which is formed of c-axis oriented superconducting phases exhibits critical current density not more than 50% of that of the oxide superconducting thin film having the aforementioned structure. Thus, the aforementioned structure is an essential element for an oxide superconducting thin film which provides excellent critical current density.

An oxide superconducting thin film has an extremely complicated fine structure, which cannot be completely controlled. According to laser ablation, however, it is possible to considerably control such a fine structure of the oxide superconducting thin film by appropriately selecting film growing conditions. The inventors have found a fine structure which is more preferable for an oxide superconducting thin film through such control of the fine structure.

The following preferred modes or conditions of the present invention contribute to improvement in critical current density of the as-grown oxide superconducting thin film:
The size of each superconducting phase in its a-b plane is preferably not more than 0.1»m in diameter. Further, the size of each superconducting phase along its c-axis is preferably equal to the thickness of the oxide superconducting thin film. In other words, the superconducting phase preferably passes through the oxide superconducting thin film along the direction of thickness.

The foreign phases which are different in crystal orientation from the c-axis oriented matrix preferably at least partially pass through the oxide superconducting thin film along the direction of thickness. The size of each foreign phase is preferably at least 0.01 »m and not more than 5 »m in diameter. Further, each foreign phase preferably has an a-axis or a b-axis which is vertically oriented with respect to the major surface of the oxide superconducting thin film.

In general, foreign phases which are prepared by a vapor phase method are of restricted types, and it is impossible to confirm an effect of an arbitrary foreign phase. In a useful foreign phase, however, Cu occupies at least 60 atomic percent among all metal elements contained therein. Further, it is particularly preferable that the foreign phases are partially formed of CuO particles.

A preferred embodiment of the present invention includes a single-crystal type matrix, or a matrix having parts which are different in a-b axis orientation from other portions.

In this specification, the term "single crystal" is widely defined to include a twin crystal.

According to the present invention, it is possible to obtain an oxide superconducting thin film having high critical current density, as understood from Examples described below.

The oxide superconducting thin film according to the present invention is grown by laser ablation, whereby the film deposition rate is increased as compared with that grown by another vapor phase method, and the film can be grown in an atmosphere under a high pressure. Thus, it is possible to obtain an oxide superconducting thin film having a dense structure, and its critical current density can be improved also in this point.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is an enlarged view showing the surface of an oxide superconducting thin film obtained according to Example 1 of the present invention.
Fig. 2 illustrates the crystal structure of a matrix 1 of the oxide superconducting thin film shown in Fig. 1;
Fig. 3 is an illustrative sectional view showing a state of distribution of foreign phase 5 and 5a which are different in crystal orientation from c-axis oriented parts 4 in the matrix 1 shown in Fig. 2; and
Fig. 4 is an enlarged view showing an estimated surface state of an oxide superconducting thin film obtained according to Example 2 of the present invention.

### DESCRIPTION OF THE PREFERRED EMBODIMENTS

### Example 1

A KrF excimer laser of 248 nm was used to form a Y-Ba-Cu-O film on an MgO(100) substrate. The film was grown using a target composed of Y, Ba and Cu in the ratios 1:2:3, under conditions of oxygen gas pressure of 100 mTorr, substrate-to target distance of 40 mm, laser energy density of 2 J/cm², laser repetition rate of 3 Hz and substrate temperature of 750°C for one hour.

Thus, a Y-Ba-Cu-O film of 500 Å in thickness was obtained.

As the result of a four-probe method, this film exhibited a critical temperature Tc of 90.5 K and critical current density Jc of 6.0 x 10⁶ A/cm² at 77.3 K. It has been impossible to attain such high critical current density in other thin film growing methods such as sputtering, MBE and the like.

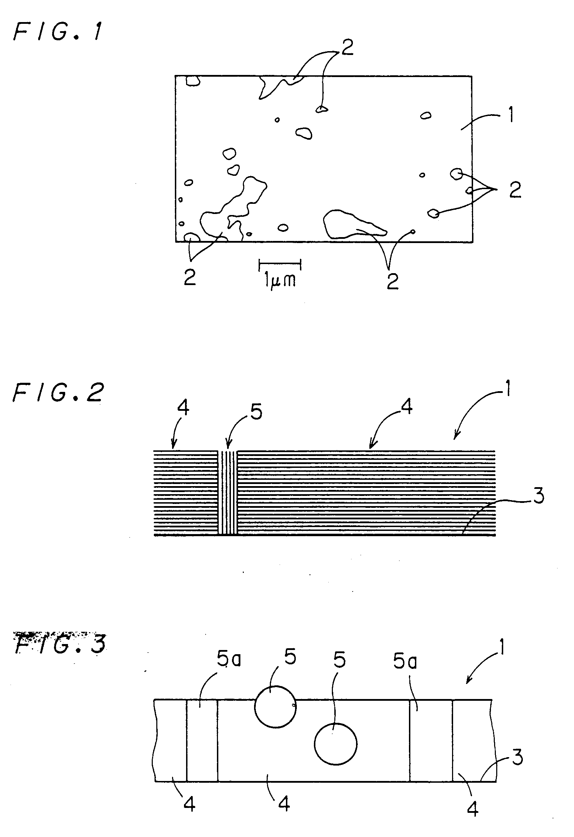

The surface of the oxide superconducting thin film was observed to find that foreign phases 2 of at least 0.01 »m and not more than 5 »m in diameter were dispersed in a matrix 1 which was formed of superconducting phases, as shown in Fig. 1. The different phases 2 were partially composed of Cu-O.

Fig. 2 shows crystal orientation of the matrix 1. In this figure, the lines show a-b planes, and c-axes are perpendicular to the a-b planes.

Referring to Fig. 2, the matrix 1 was mostly formed of c-axis oriented parts 4 whose a-b planes were oriented in parallel with a major surface of the superconducting thin film, i.e., a substrate surface 3. This matrix 1 was provided with a foreign phase 5, which was different in crystal orientation from the c-axis oriented parts 4. This foreign phase 5 had an a-axis or a b-axis which was oriented perpendicularly to the major surface of the superconducting thin film, i.e., the substrate surface 3.

The foreign phase 5 of different crystal orientation was composed of Y, Ba and Cu in the ratios 1:2:3, similarly to the c-axis oriented parts 4.

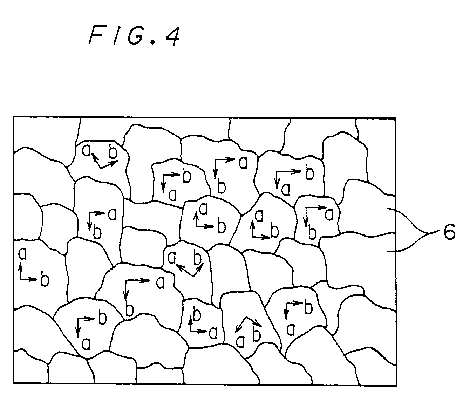

Fig. 3 shows a section of the superconducting thin film. As understood from Fig. 3, such foreign phases 5 of different crystal orientation were distributed in various modes with respect to the direction of thickness of the superconducting thin film, and some foreign phases 5a passed through the superconducting thin film along the direction of thickness.

### Reference Example 1

An oxide superconducting film was obtained through a similar process to Example 1, excepting that the substrate temperature was 800°C.

In the as-formed oxide superconducting thin film, CuO particles of at least 7 »m in diameter were observed. Further, it was proved that the matrix was entirely c-axis oriented perpendicularly to the substrate surface. This oxide superconducting thin film exhibited critical current density Jc of 1.2 x 10⁶ A/cm² at 77.3 K.

### Example 2

A KrF excimer laser of 248 nm was used to form a Y-Ba-Cu-O film on an MgO(100) substrate. The film was formed using a target composed of Y, Ba and Cu in the ratios 1:2:3 under conditions of oxygen gas pressure of 200 mTorr, substrate-to-target distance of 60 mm, laser energy density of 2.5 J/cm², laser repetition rate of 40 Hz, substrate temperature of 700°C, and film deposition rate of 2500 Å/min. for four minutes.

The aforementioned film deposition rate is extremely high as compared with a condition of 12 to 60 Å/min., which is known as being capable of obtaining an oxide superconducting thin film having relatively high critical current density by RF sputtering.

The surface of the as-grown oxide superconducting thin film was observed with a scanning electron microscope, to prove that it was formed of particles of 0.005 to 0.1 »m in particle size. As to X-ray diffraction, no diffraction but (001) was observed and it was ascertained that this film was c-axis oriented. Through refraction high-energy electron beam diffraction, a ring-shaped diffraction pattern was observed above the oxide superconducting thin film, which was determined as being polycrystalline. As the result of observation with a transmission electron microscope, it was proved that the film was mostly formed of superconducting phase particles which were uniformly oriented along a-b directions, and partially formed of superconducting phase particles which were different in orientation along a-b directions from the uniformly oriented particles.

Fig. 4 shows a structure, estimated from the above results of analysis, of the superconducting thin film. Referring to Fig. 4, numeral 6 denotes superconducting phase particles.

Critical current density Jc of this film was measured by a four-probe method. The result was 2.2 x 10⁶ A/cm² at 77.3 K.

### Reference Example 2

Oxide superconducting thin films were obtained through a process similar to Example 2, excepting that the substrate temperatures were 600°C and 750°C.

These oxide superconducting thin films were observed with a scanning electron microscope, to prove that the thin film prepared at the substrate temperature of 600°C was formed of particles of 0.001 to 0.005 »m in particle size and that prepared at 750°C was formed of particles of 0.05 to 1.1 »m in particle size.

As to critical current density Jc, the former film exhibited 8.8 x 10⁵ A/cm² at 77.3 K, and the latter film exhibited 4.3 x 10⁵ A/cm² at 77.3 K.

Although the present invention has been described and illustrated in detail, it is clearly understood that the same is by way of illustration and example only and is not to be taken by way of limitation, the scope of the present invention being limited only by the terms of the appended claims.

## Claims

1. An oxide superconducting thin film formed by laser ablation, comprising:
a matrix (1) formed of c-axis oriented superconducting phases (4, 6); characterized by further comprising
foreign phases (2, 5, 5a) having different crystal orientations compared to said matrix (1).

2. The oxide superconducting thin film in accordance with claim 1, wherein the size of each said superconducting phase (4, 6) in its a-b plane is not more than 0.1 »m in diameter.

3. The oxide superconducting thin film in accordance with claims 1 or 2, wherein the size of each said superconducting phase (4, 6) in its c-axis direction is equal to the thickness of said oxide superconducting thin film.

4. The oxide superconducting thin film according to anyone of the preceding claims, wherein at least a part (5a) of said foreign phases (2, 5, 5a) extend through said oxide superconducting thin film along the direction of thickness of the film.

5. The oxide superconducting thin film according to anyone of the preceding claims, wherein the size of each said foreign phases (2, 5, 5a) is at least 0.01 »m and not more than 5 »m in diameter.

6. The oxide superconducting thin film according to anyone of the preceding claims, wherein each said foreign phases (2, 5, 5a) has an a-axis or a b-axis perpendicularly oriented with respect to the major surface (4, 6) of said oxide superconducting thin film.

7. The oxide superconducting thin film according to anyone of the preceding claims, wherein each of said foreign phases (2, 5, 5a) contains at least one metal element, and Cu occupies at least 60 atomic percent among all metal elements contained in said foreign phase (2, 5, 5a).

8. The oxide superconducting thin film according to anyone of the preceding claims, wherein said foreign phases (2, 5, 5a) contain CuO particles.

9. The oxide superconducting thin film according to anyone of the preceding claims, wherein said matrix (1) is of a single crystal type.

10. The oxide superconducting thin film according to anyone of the preceding claims, wherein said matrix (1) has parts (4, 6) being different in orientation along a-b directions from other parts (4, 6).

## Patentansprüche

1. Ein mittels Laserablation gebildeter dünner Film aus supraleitendem Oxid, mit:
einer Matrix (1), die aus c-Achsen-orientierten supraleitenden Phasen (4, 6) gebildet ist, dadurch gekennzeichnet, daß sie desweiteren
fremden Phasen (2, 5, 5a) umfaßt, die im Vergleich zu der Matrix (1) unterschiedliche Kristallorientierungen aufweisen.

2. Der dünne Film aus supraleitendem Oxid nach Anspruch 1, worin die Größe einer jeden der genannten supraleitenden Phasen (4, 6) in ihrer a-b Ebene im Durchmesser nicht mehr als 0,1 »m beträgt.

3. Der dünne Film aus supraleitendem Oxid nach Anspruch 1 oder 2, worin die Größe einer jeden der genannten supraleitenden Phasen (4, 6) in Richtung ihrer c-Achse der Dicke des dünnen Filmes aus supraleitendem Oxid spricht.

4. Der dünne Film aus supraleitendem Oxid nach einem der vorigen Ansprüche, worin wenigstens ein Teil (5a) der genannten fremden Phasen (2, 5, 5a) sich durch den genannten dünnen Film aus supraleitendem Oxid entlang der Richtung der Dicke des Filmes erstreckt.

5. Der dünne Film aus supraleitendem Oxid nach einem der vorigen Ansprüche, worin die Größe einer jeden der genannten fremden Phasen (2, 5, 5a) im Durchmesser wenigstens 0,01 »m und nicht mehr als 5 »m beträgt;

6. Der dünne Film aus supraleitendem Oxid nach einem der vorigen Ansprüche, worin ein jede der genannten fremden Phasen (2, 5, 5a) ein a-Achse oder eine b-Achse aufweist, die bezüglich der Hauptoberfläche (4, 6) des genannten dünnen Filmes aus supraleitendem Oxid senkrecht orientiert ist.

7. Der dünne Film aus supraleitendem Oxid nach einem der vorigen Ansprüche, worin ein jede der genannten fremden Phasen (2, 5, 5a) wenigstens ein Metallelement enthält, und Cu wenigstens 60 Atomprozent zwischen all den Metallelementen einnimmt, die in der genannten fremden Phase (2, 5, 5a) enthalten sind.

8. Der dünne Film aus supraleitendem Oxid nach einem der vorigen Ansprüche, worin die genannten fremden Phasen (2, 5, 5a) CuO- Partikel enthalten.

9. Der dünne Film aus supraleitendem Oxid nach einem der vorigen Ansprüche, worin die genannte Matrix (1) vom einkristallinen Typ ist.

10. Der dünne Film aus supraleitendem Oxid nach einem der vorigen Ansprüche, worin die Matrix (1) Teile (4, 6) aufweist, die in ihrer Orientierung entlang a-b-Richtungen von anderen Teilen (4, 6) verschieden sind.

## Revendications

1. Un film mince constitué d'oxyde supraconducteur réalisé par ablation a l'aide d'un rayon laser, comprenant une matrice (1) constituée d'une phase supraconductrice (4, 6) orientée selon l'axe c, film caractérisé en ce qu'il comprend en outre des phases d'addition (2, 5, 5a) ayant des orientations cristallines différentes de celle de ladite matrice (1).

2. Le film mince d'oxyde supraconducteur selon la revendication 1, à l'intérieur duquel la taille de chacune desdites phases supraconductrices (4, 6) prises dans le plan a-b ne dépasse pas 0,1 »m de diamètre.

3. Le film mince d'oxyde supraconducteur selon les revendications 1 ou 2, à l'intérieur duquel la taille de chacune desdites phases supraconductrices (4, 6) prises dans le sens de l'axe c est égale à l'épaisseur dudit film mince constitué d'oxyde supraconducteur.

4. Le film mince d'oxyde supraconducteur selon l'une quelconque des revendications précédentes, à l'intérieur duquel un domaine au moins (5a) desdites phases d'addition (2, 5, 5a) s'étend à travers ledit film mince d'oxyde supraconducteur dans le sens de l'épaisseur du film.

5. Le film mince d'oxyde supraconducteur selon l'une quelconque des revendications précédentes, à l'intérieur duquel la taille de chacune desdites phases d'addition (2, 5, 5a) fait au moins 0,01 »m de diamètre et ne dépasse pas 5 »m de diamètre.

6. Le film mince d'oxyde supraconducteur selon l'une quelconque des revendications précédentes, à l'intérieur duquel chacune desdites phases d'addition (2, 5, 5a) présente un axe a ou un axe b orienté perpendiculairement à la surface principale (4, 6) dudit film mince constitué d'oxyde supraconducteur.

7. Le film mince d'oxyde supraconducteur selon l'une quelconque des revendications précédentes, à l'intérieur duquel chacune desdites phases d'addition (2, 5, 5a) contient au moins un élément métallique au sein duquel Cu fait au moins 60% en pourcentage atomique de tous les éléments métalliques contenus dans ladite phase d'addition (2, 5, 5a).

8. Le film mince d'oxyde supraconducteur selon l'une quelconque des revendications précédentes, à l'intérieur duquel lesdites phases d' addition (2, 5, 5a) contiennent des particules de CuO.

9. Le film mince d'oxyde supraconducteur selon l'une quelconque des revendications précédentes, à l'intérieur duquel ladite matrice (1) est de type monocristalline.

10. Le film mince d'oxyde supraconducteur selon l'une quelconque des revendications précédentes, à l'intérieur duquel ladite matrice (1) présente des domaines (4, 6) qui, lorsqu'ils sont orientés selon l'axe a-b, sont différents des autres domaines (4, 6).
